(19) Europäisches Patentamt
European Patent Office
Office européen des brevets

(11) Numéro de publication: **0 119 130**
**B1**

(12) **FASCICULE DE BREVET EUROPÉEN**

(45) Date de publication du fascicule du brevet: **29.06.88**

(51) Int. Cl.⁴: **C 30 B 25/10**, C 30 B 23/06, C 30 B 29/12

(21) Numéro de dépôt: **84400417.6**

(22) Date de dépôt: **02.03.84**

(54) **Dispositif chauffant transparent comprenant au moins deux zones à températures différentes.**

(30) Priorité: **08.03.83 FR 8303746**

(43) Date de publication de la demande: **19.09.84 Bulletin 84/38**

(45) Mention de la délivrance du brevet: **29.06.88 Bulletin 88/26**

(84) Etats contractants désignés: **BE CH DE FR GB LI NL**

(56) Documents cité:
**GB-A-907 164**
**US-A-3 962 670**

**Gmelins Handbuch der anorganischen Chemie (1972), Vol. 46, page 61**
**Ullmanns Encyklopädie der technischen Chemie, 4ième édition, Vol. 15, page 131**

(73) Titulaire: **CENTRE NATIONAL D'ETUDES SPATIALES, 129, Rue de l'Université, F-75007 Paris (FR)**

(72) Inventeur: **Brisson, Pierre Charles, 1 rue du Square, F-63110 Beaumont (FR)**
Inventeur: **Cadoret, Robert, 3 rue Emile Zola, F-63400 Chamalières (FR)**
Inventeur: **Omaly, Jean, 11 Avenue Jocelyn Bargoin, F-63130 Royat (FR)**

(74) Mandataire: **de Boisse, Louis, CABINET DE BOISSE 37, Avenue Franklin D. Roosevelt, F-75008 Paris (FR)**

**EP 0 119 130 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1988

**Description**

L'invention concerne un dispositif chauffant transparent comprenant au moins deux zones de travail à températures différentes, utile notamment pour la production de monocristaux, par exemple de monocristaux de α-Hg $I_2$.

Le demandeur a décrit dans la demande de brevet FR-A-247 8 135 un procédé de production de monocristaux dans lequel on utilise une enceinte transparente close, de forme générale cylindrique, divisée en au moins deux zones (zone de source et zone de dépôt et de puits) que l'on doit chauffer et maintenir à des températures différentes mais qui peuvent être très proches l'une de l'autre. Comme il est nécessaire de pouvoir suivre visuellement la formation et la croissance des monocristaux, il faut utiliser un dispositif de chauffage laissant apparaître l'enceinte transparente close. On peut recourir à cette fin à des bains d'huile, portés et maintenus à des températures appropriées par des systèmes de régulation idoines. Un tel système n'est toutefois pas entièrement satisfaisant car d'un emploi malaisé et peu souple. En outre, il est difficile d'éviter des fuites d'huile accidentelles. Enfin, les bains d'huile chauds, quoique transparents, constituent néanmoins une gêne à l'observation visuelle et surtout à la mise en oeuvre de méthodes d'observation ou de mesure sophistiquées, telles que l'anémométrie laser ou l'holographie laser.

Il est connu, par ailleurs, par l'ouvrage dénommé Gmelins Handbuch der anorganischen Chemie (1972), Volume 46, Partie C1, page 61, d'employer de minces couches de $SnO_2$ dopé sur un substrat de verre pour réaliser des surfaces conductrices de l'électricité, un exemple d'application étant la fabrication de fours tubulaires transparents.

La présente invention vise à fournir un dispositif chauffant transparent perfectionné dans lequel le chauffage des différentes zones du dispositif est assuré par effet Joule et qui comprend un élément chauffant transparent rapporté permettant de régler localement la température régnant dans le dispositif, par exemple pour pouvoir induire une nucléation de monocristal en un point précis.

Plus particulièrement, l'invention concerne un dispositif chauffant transparent ayant au moins deux zones de travail pouvant être chauffées à des températures différentes, qui comprend : une enceinte transparente ouvrable, formée d'au moins deux parties amovibles et accouplables de façon étanche, cette enceinte étant pourvue d'un orifice pouvant être relié à une source de vide poussé ou à des moyens d'introduction d'une atmosphère, caractérisé en ce qu'il comprend des moyens de chauffage constitués par au moins une couche électro-conductrice résistante transparente appliquée sur ladite enceinte, et des moyens d'application d'un courant électrique en au moins deux points espacés de ladite couche, de façon à permettre le chauffage de l'enceinte par effet Joule, au moins une portion de la surface de l'enceinte étant depourvue de couche électro-conductrice résistante et en ce qu'il comprend, en outre, au moins un élément chauffant électrique alimenté de façon indépendante en énergie électrique et rapporté sur ladite portion de la surface de l'enceinte dépourvue de couche électro-conductrice résistante, cet élément étant constitué d'un substrat transparent revêtu sur sa face interne d'une couche électro-conductrice résistante transparente, et ledit substrat ayant la forme d'une plaquette ou d'une section de cylindre.

La couche électro-conductrice résistante peut être en contact thermique direct, c'est-à-dire déposée directement sur la surface extérieure et/ou intérieure de l'enceinte, ou indirect, c'est-à-dire déposée sur un élément (plaque, bague ou analogue) que l'on peut appliquer lui-même sur l'enceinte. Bien entendu, des combinaisons quelconques de ces modes de chauffage peuvent être utilisées.

La couche électroconductrice résistante est constituée d'un très mince dépôt d'un composé métallique, tel que $SnO_2$, $In_2O_3$ ou $PbF_2$, de préférence dopé. A ce jour, on préfère utiliser du $SnO_2$ dopé pour constituer la couche électro-conductrice résistante. $SnO_2$ est un oxyde semi-conducteur ayant un type de conduction $\underline{n}$ qui résulte de vacances d'oxygène et qui peut être augmenté par dopage, par exemple au fluor.

La ou les couche(s) électro-conductrice(s) résistante(s) n'ont besoin d'avoir qu'une épaisseur très faible, inférieure à 2 micromètres. On peut, par exemple, dans le cas de $SnO_2$, utiliser une ou des couche(s) de $SnO_2$ d'une épaisseur de l'ordre de 0,2 micromètre. Une telle couche peut être déposée facilement par un processus chimique en phase vapeur et adhère très bien à la paroi du dispositif. Elle est transparente dans la gamme de longueurs d'onde du visible.

Le dispositif de l'invention peut comporter une seule couche électro-conductrice résistante dont l'épaisseur variera le long du dispositif en fonction du profil de température désiré dans ce dispositif, ou comporter deux ou plusieurs couches, d'épaisseurs égales ou différentes, adjacentes, réparties le long du dispositif et alimentées en énergie électrique, soit indépendamment par des alimentations distinctes, soit en série à partir d'une alimentation unique avec utilisation de shunts réglables associés à au moins certaines des couches. Cette dernière configuration (utilisation d'une alimentation unique avec shunts réglables) constitue un mode de réalisation préféré.

Le dispositif de l'invention permet de couvrir une large gamme de températures. On a pu atteindre, à titre indicatif, des températures allant jusqu'à 750° C.

La description qui va suivre, faite en regard des dessins annexés, fera bien comprendre la présente invention. Sur les dessins :

La figure 1 est une vue schématique, en coupe axiale longitudinale, d'une installation convenant au dépôt d'un revêtement de $SnO_2$ dopé sur un substrat tubulaire. La figure 2 est une vue schématique, en coupe axiale longitudinale, d'un dispositif chauffant selon l'invention. La figure 3 illustre une variante de réalisation du dispositif de la figure 2. La figure 4 est une vue schématique, en coupe axiale longitudinale, d'un dispositif

selon l'invention comportant des éléments de support intérieurs amovibles. La figure 5 est une vue schématique, en coupe axiale longitudinale, d'un dispositif selon l'invention adapté à la production de monocristaux lamellaires. La figure 6 est une vue schématique, en coupe transversale d'un dispositif selon l'invention adapté à la production de monocristaux de forme annulaire. La figure 7 est une vue schématique partielle illustrant une autre variante de réalisation du dispositif selon l'invention.

Bien que l'invention ne soit pas limitée à l'emploi de couches résistives à base de $SnO_2$, on décrira l'invention plus particulièrement à propos de l'emploi de telles couches.

Le dépôt d'une couche mince d'oxyde d'étain est basé sur la réaction suivante :

$$SnCl_4 + 2H_2O \rightarrow SnO_2 + 4\,HCl.$$

On conduit la réaction en phase vapeur à l'aide d'une installation appropriée, telle que celle représentée par la figure 1. Cette installation comprend un pulvérisateur 1 pulvérisant une solution de départ dans un flux d'azote et envoyant le pulvérisat dans un four à gradient de température désigné par la référence générale 2. Ce four 2 est formé d'un tube de laboratoire 3 en quartz d'une longueur de 1 050 mm et d'un diamètre de 52 mm muni de deux éléments chauffants 4 et 5 d'une puissance de 1 500 watts, disponibles dans le commerce sous la marque déposée THERMOCOAX. L'élément 4 définit une zone de pyrolyse tandis que l'élément 5 définit une zone de déposition moins chaude dans laquelle est placé le substrat 6 à revêtir de $SnO_2$. Le substrat 6 sera généralenent constitué d'un tube 7 de verre ou de quarts. Ce tube 7 peut être maintenu dans le four par une canne métallique 8, par exemple en aluminium, enfilée dans des bouchons 9 obturant les extrémités du tube 7. De la sorte, le dépôt de $SnO_2$ se fait uniquement sur l'extérieur du tube 7. Si on voulait, par contre, effectuer le dépôt à l'intérieur du tube 7, on pourrait maintenir le tube 7 centré dans le tube 3 au moyen de deux couronnes disposées aux extrémités du tube 7 et dont les diamètres intérieur et extérieur correspondraient aux diamètres des tubes 7 et 3, respectivement. On pourrait également imprimer un mouvement rotatif au substrat pour accroître l'uniformité du revêtement de $SnO_2$ déposé. Des éléments calorifuges 10 et 11 formés de fibres isolantes de la marque déposée FIBERFAX, sont disposés autour des éléments 4 et 5, respectivement. Un manchon calorifuge 12 est prévu autour du tube 3 entre les éléments 10 et 11. Une tôle 13 en acier inoxydable est montée entre le tube 3 et l'élément chauffant 5 à titre d'écran thermique.

La solution de départ utilisée avait la composition suivante : 50 g d'eau, 50 g d'éthanol, 50 g de chlorure d'étain hydraté $Cl_4Sn, 5H_2O$, et 2 g de fluorure d'ammonium.

Le fluorure d'ammonium sert à doper le $SnO_2$ et ainsi, à abaisser sa résistivité. La solution ci-dessus est optimale pour l'obtention de la transmission optique la plus élevée et d'une résistance comprise dans la gamme de 10 à 40 ohms/carré.

Les températures Tpyr et Tdep des zones de pyrolyse et de déposition doivent être réglées indépendamment l'une de l'autre. Une Tpyr trop élevée conduira à un dépôt peu adhérent et d'aspect rugueux. A l'inverse, une Tpyr trop faible entraînera un dépôt blanchâtre non-homogène. A titre indicatif, une Tpyr de l'ordre de 600° C et une Tdep comprise dans la gamme de 350-500° C donnent des résultats satisfaisants. Le substrat revêtu doit être sorti du four suffisamment lentement pour éviter un effet de trempe.

Un débit correct de pulvérisation pour l'installation décrite est, à titre indicatif, de l'ordre de 1-3 litres/minute.

La résistance en ohms/carré du revêtement de $SnO_2$ produit est dépendante d'un grand nombre de facteurs tels que, bien entendu, l'épaisseur du revêtement, mais aussi de la température du substrat (ou de la zone de déposition), de la température de la zone de pyrolyse, du débit de pulvérisation, de la composition de la solution de départ, de l'uniformité du revêtement, etc... D'un point de vue pratique, comme il n'est pas possible de maîtriser tous ces paramètres avec précision, un contrôle avec un ohm-mètre permettra d'une part d'établir une carte résistive du ou des revêtements de $SnO_2$ et de tester, d'autre part, l'uniformité de ce ou ces revêtements. A cet égard, un premier examen de la qualité du ou des revêtements peut se faire immédiatement en observant les interférences optiques qui se forment lorsque l'épaisseur du revêtement est inférieure au micromètre. Tout gradient local d'épaisseur même faible se traduit par un aspect irisé du revêtement en lumière réfléchie.

Il est difficile d'obtenir un dépôt d'épaisseur constante sur toute la longueur d'un substrat dès lors que cette dernière dépasse une quinzaine de centimètres. Ceci n'est toutefois pas gênant dans la mesure où le réglage de la température dans les diverses zones du dispositif s'opère par un réglage de l'alimentation électrique et non par un réglage des résistances des revêtements de $SnO_2$.

D'autres détails concernant le dépôt de minces couches résistives de $SnO_2$ ou d'autres composés de métaux pourront être trouvés dans les documents suivants :

- l'article "Spraged Films of Indium Tin Oxide and fluorine doped tin oxide of large surface area" de R. Pommier, G. Gril et J. Marucchi paru dans Thin Solid Films, 77, 1981, 91-97, Metallurgical and Protective Coatings,
- l'article de R.R. Chamberlin et J.S. Sharkman paru dans J. Electrochemical Soc. 113 (1966) 86,
- l'article de J. C. Manufacier, M. de Murcia et J.P. Fillard paru dans Mater. Res. Bull. 10 (1975) 1215.

La figure 2 illustre un dispositif chauffant transparent comprenant trois zones à températures différentes utile pour la production de monocristaux de $\alpha$-Hg $I_2$ et bien que non représenté, au moins un élément chauffant rapporté tel que décrit en liaison avec la figure 7.

Ce dispositif comprend un corps tubulaire 20, en verre Pyrex, fermé à une de ses extrémités et pourvu d'un

bouchon rodé 21 à son autre extrémité. Ce bouchon est pourvu d'une tubulure 22 raccordable à une pompe à vide et sur laquelle est montée une vanne 23. Le corps 20 qui a un diamètre de 2,4 cm, est pourvu sur sa surface extérieure de trois revêtements 24, 25 et 26 de $SnO_2$ successifs contigus d'une longueur de 10 cm chacun. Les résistances R1, R2 et R3 de ces revêtements 24, 25 et 26 sont de 92, 73,3 et 106,8 ohms respectivement. Les revêtements 24, 25 et 26 sont obtenus en déposant un revêtement unique sur le corps 20 puis en enlevant, sur une faible largeur, le dépôt $SnO_2$ aux limites entre les revêtements désirés 24 et 25 et 25 et 26, afin de délimiter lesdits revêtements.

Aux extrémités de chaque revêtement de $SnO_2$ sont montées des électrodes annulaires 28, par exemple en cuivre, collées à l'aide de laque d'argent afin d'améliorer la conductivité et reliées par paire à une source de courant. Du fait de la présence de ces conducteurs ohmiques, un problème de points froids a été rencontré au niveau de ces points de contact, créé par la diminution de résistivité locale. Ce problème peut être surmonté en prévoyant des anneaux 29 de matière thermo-isolante, par exemple en laine réfractaire, maintenus par un ruban de polytétrafluoroéthylène (Téflon®) autour desdites électrodes. Compte tenu de la faible inertie thermique du dispositif de l'invention, il convient de le protéger des mouvements d'air en le plaçant dans une enceinte 30 en une matière transparente, pouvant supporter un vide primaire de manière à limiter les pertes thermiques dues à des mouvements convectifs autour du système chauffant. On applique aux revêtements diverses alimentations stabilisées et on mesure ou détermine l'intensité en ampères et la puissance en watts de chacun de ces revêtements et la température en °C atteinte dans la zone correspondante du dispositif chauffant. Les résultats sont récapitulés dans le tableau ci-dessous :

| Revêtement | Tension | Intensité | Puissance | Température |
|---|---|---|---|---|
| | 41 | 0,44 | 18,64 | 100 |
| 24 | 41,5 | 0,45 | 18,66 | 102 |
| | 42 | 0,46 | 19,32 | 104 |
| | 46 | 0,49 | 22,54 | 115 |
| | 27 | 0,38 | 10,26 | 95 |
| 25 | 29 | 0,40 | 11,6 | 106 |
| | 30,3 | 0,42 | 12,73 | 112 |
| | 33 | 0,31 | 10,23 | 100 |
| 26 | 36,2 | 0,35 | 12,67 | 108 |
| | 38 | 0,37 | 14,07 | 115 |

Ces résultats montrent à l'évidence la possibilité de régler la température dans chacune des zones du dispositif en réglant la tension d'alimentation des revêtements de $SnO_2$ entourant lesdites zones.

La figure 3 illustre une variante de réalisation dans laquelle, au lieu d'alimenter chacun des revêtements résistifs 24, 25 et 26 par une alimentation individuelle, on a recours à une alimentation en série des trois revêtements qui d'ailleurs, dans cette variante, ne forment qu' un seul revêtement continu (on n'enlève pas de $SnO_2$ aux limites entre les revêtements 24-25 et 25-26, à partir d'une source unique (non représentée) et à l'utilisation de rhéostats disposés en parallèle avec au moins certains des revêtements résistifs et faisant office de shunts variables.

Av moins un élément chauffant rapporté (60) décrit en liaison avec la figure 7 est cependant prevu.

En supposant que l'on veuille avoir une température de source Ts (revêtement 24 de résistance $R_1$) de 115°C, une température de dépôt Td (revêtement 25 de résistance R2) de 112°C et une température de puits Tp (revêtement 26 de résistance R3) de 108°C on voit d'après les résultats du tableau afférent au mode de réalisation 1, que I (R1) doit être égal à 0,49 A, I (R2) doit être égal à 0,42 A, I (R3) doit être égal à 0,35 A et que la tension doit être égale à 112,5 V (46 + 30,3 + 36,2). Ceci peut être obtenu en ayant recours à des shunts $S_2$ et $S_3$ ayant des résistances de 380 et 255 ohms respectivement, placés en parallèle avec les revêtements 25 et 26, respectivement, comme déterminé par un calcul simple.

Une modification légère de la résistance d'un des shunts entraînera une variation de l'intensité traversant le revêtement résistif correspondant et, donc, une variation de température de la zone correspondante du dispositif de l'invention. Il est possible ainsi d'opérer un réglage très fin de la température dans chaque zone. Ceci est important, en particulier pour la croissance de monocristaux de $\alpha$-Hg $I_2$ qui est sensible à des écarts de température aussi faibles que de 0,1°C.

En théorie, il serait nécessaire de modifier la tension d'alimentation totale dès que l'on fait varier la valeur d'un shunt associé à une zone, ceci dans le but de conserver les intensités désirées et donc les températures sélectionnées dans les autres zones. Cependant, lorsque la valeur du shunt est importante par rapport à la résistance R du revêtement de $SnO_2$, c'est-à-dire au moins égale à cette résistance, la variation d'intensité et donc de température dans les autres zones résultant de la variation du shunt est faible si bien qu'on peut, en pratique, négliger d'ajuster la valeur de la tension totale. Bien entendu, si désiré, un tel ajustement est parfaitement concevable.

D'autres types de branchement électrique sont possibles. Ainsi, au lieu d'effectuer des jonctions électriques

parallèles aux génératrices du tube 20, on pourrait prévoir des jonctions électriques obliques, par exemple afin d'obtenir une meilleure localisation de la sursaturation. Par jonction oblique on veut dire que les deux bornes d'alimentation électrique sont situées sur des génératrices différentes du tube.

Le tube 20 peut avoir une section circulaire comme représenté, carrée, rectangulaire ou autre.

On peut aménager de diverses manières l'intérieur de l'enceinte chauffante. On peut bien entendu utiliser directement la surface interne de ladite enceinte comme support de la source de Hg $I_2$, du ou des monocristaux en cours de croissance, et du puits d'Hg $I_2$, mais on préfère utiliser des éléments amovibles à cette fin. On peut prévoir, par exemple, d'utiliser des "cartouches" comme représenté en 40, 41 et 42 sur la figure 4. Ces cartouches servent à supporter la source de matière à monocristalliser (cartouche 40), à recevoir le monocristal à déposer (cartouche 41) et le puits de matière (cartouche 42) et sont formées à partir d'un tube de taille inférieure à la taille du tube formant enceinte chauffante afin de pouvoir être introduites dans ce dernier. L'emploi de ces cartouches permet de préparer la source et le puits de matière dans un dispositif distinct et, aussi, d'éviter de "salir" la paroi interne de l'enceinte chauffante, facilitant ainsi son réemploi.

Avantageusement, toutefois, dans le cas d'une enceinte tubulaire de section carrée ou rectangulaire comme l'illustre la figure 5, on remplace la cartouche destinée à supporter le ou les monocristaux par une série de lames planes parallèles espacées 44 s'étendant tout le long de l'enceinte, entre la cartouche-source et la cartouche-puits, de façon à favoriser la formation d'une pluralité de monocristaux lamellaires, tels que 45. Les lames peuvent être réalisées en divers matériaux (verre, quartz, mica, par exemple) et peuvent être ensemencées au préalable au moyen de petits monocristaux lamellaires. Dans le cas d'une enceinte de section circulaire, on pourrait prévoir une pluralité de tubes concentriques 54 à la place des lames planes, comme illustré par la figure 6, afin d'obtenir des monocristaux de forme sensiblement annulaire.

Comme illustré sur la figure 7, selon l'invention on utilise au moins un élément chauffant transparent rapporté et alimenté séparément en énergie électrique pour contrôler indépendamment en température une zone de section désirée au sein de la zone isotherme de dépôt et de croissance d'un monocristal. Cet élément chauffant 60, qui peut être d'ailleurs, incorporé à l'un quelconque des dispositifs précédents, porte une couche de $SnO_2$ sur sa face interne et est appliqué sur une portion de l'enceinte dans la zone de dépôt, d'où l'on a enlevé la couche résistive de $SnO_2$. L'élément 60, qui peut être par exemple en verre Pyrex R ou en quartz, est transparent et a une forme correspondant au profil de la portion d'enceinte sur laquelle on l'applique, par exemple en forme de plaquette pour une enceinte à section carrée ou rectangulaire ou en forme de section de cylindre pour une enceinte à section circulaire. L'élément 60 est alimenté indépendamment en 61, 62, en énergie électrique. L'intérêt de l'emploi d'un élément de ce genre est de pouvoir abaisser localement la température avec création concomitante dans l'enceinte de sursaturations locales plus élevées et, donc, d'induire une ducléation en des points précis de l'ampoule. Egalement, après nucléation, on peut, grâce à l'élément 60, contrôler de façon continue la croissance du monocristal. Bien entendu, on peut utiliser en même temps plus d'un élément chauffant rapporté.

**Revendications**

1. Un dispositif chauffant transparent ayant au moins deux zones de travail pouvant être chauffées à des températures différentes, qui comprend : une enceinte transparente ouvrable, formée d'au moins deux parties (20, 21) amovibles et accouplables de façon étanche, cette enceinte étant pourvue d'un orifice (22) pouvant être relié à une source de vide poussé ou à des moyens d'introduction d'une atmosphère, caractérisé en ce qu'il comprend des moyens de chauffage constitués par au moins une couche électro-conductrice résistante transparente (24, 25, 26) appliquée sur ladite enceinte, et des moyens d'application d'un courant électrique en au moins deux points espacés de ladite couche, de façon à permettre le chauffage de l'enceinte par effet Joule, au moins une portion de la surface de l'enceinte étant dépourvue de couche électro-conductrice résistante et en ce qu'il comprend, en outre, au moins un élément chauffant électrique (60) alimenté de façon indépendante en énergie électrique et rapporté sur ladite portion de la surface de l'enceinte dépourvue de couche électroconductrice résistante, cet élément étant constitué d'un substrat transparent revêtu sur sa face interne d'une couche électro-conductrice résistante transparente, et ledit substrat ayant la forme d'une plaquette ou d'une section de cylindre.

2. Un dispositif selon la revendication 1, caractérisé en ce que la couche électro-conductrice résistante est déposée directement sur la surface extérieure de l'enceinte.

3. Un dispositif selon la revendication 1 ou 2, caractérisé en ce que la couche électro-conductrice est formée d'oxyde d'étain et a une épaisseur inférieure à deux micromètres.

4. Un dispositif selon l'une quelconque des revendications 1 à 3, caractérisé en ce qu'il comprend plusieurs couches électro-conductrices réparties le long du dispositif et alimentées indépendamment en énergie électrique par des alimentations distinctes.

5. Un dispositif selon l'une quelconque des revendications 1 à 3, caractérisé en ce qu'il comprend plusieurs couches électro-conductrices réparties le long du dispositif, connectées en séries et alimentées par une source de courant unique, un shunt ($S_2$, $S_3$) de valeur réglable étant associé à au moins l'une de ces couches.

6. Un dispositif selon l'une quelconque des revendications 1 à 5, caractérisé en ce qu'il comprend des éléments amovibles internes ou "cartouches" (40, 41, 42) servant de support à la source de matière à

monocristalliser, au monocristal à développer et au puits de matière.

7. Un dispositif selon la revendication 6, caractérisé en ce que l'enceinte est de section carrée ou rectangulaire et en ce que l'élément servant de support au monocristal est constitué de plusieurs lames parallèles (44) espacées.

8. Un dispositif selon la revendication 6, caractérisé en ce que l'enceinte est de section circulaire et en ce que l'élément servant de support au monocristal est constitué de tubes concentriques (54).

**Patentansprüche**

1. Transparente Heizvorrichtung mit mindestens zwei Arbeitszonen, die auf unterschiedliche Temperaturen aufheizbar sind, mit: einer transparenten Umhüllung, die geöffnet werden kann und von mindestens zwei lösbaren und abgedichtet verbindbaren Teilen (20, 21) gebildet wird, wobei die Umhüllung mit einer Öffnung (22) versehen ist, die an einer Hochvakuumquelle oder an einer Einrichtung zum Zuführen einer Atmosphäre anschließbar ist, gekennzeichnet durch Heizmittel, die gebildet werden von mindestens einer transparenten, elektrisch leitenden Widerstandsschicht (24, 25, 26), die an der Umhüllung anliegt, und Mitteln zum Anlegen eines elektrischen Stromes an mindestens zwei beabstandeten Stellen dieser Schicht, derart, daß die Umhüllung durch den Joule-Effekt aufheizbar ist, wobei mindestens ein Teil der Oberfläche der Umhüllung von der elektrisch leitenden Widerstandsschicht frei ist, und ferner durch mindestens ein elektrisches Heizelement (60), das unabhängig mit elektrischer Energie versorgt wird und an dem von der elektrisch leitenden Widerstandsschicht freien Abschnitt der Oberfläche der Umhüllung angebracht ist, wobei dieses Element von einem transparenten Substrat gebildet wird, das an seiner Innenseite mit einer transparenten, elektrisch leitenden Widerstandsschicht versehen ist und das die Form einer Scheibe oder eines Zylinderabschnittes hat.

2. Vorrichtung nach Anspruch 1, dadurch gekennzeichnet, daß die elektrisch leitende Widerstandsschicht direkt auf der Außenfläche der Umhüllung aufgebracht ist.

3. Vorrichtung nach Anspruch 1 oder 2, dadurch gekennzeichnet, daß die elektrisch leitende Schicht aus Zinnoxid besteht und eine Dicke hat, die kleiner ist als 2 µm.

4. Vorrichtung nach einem der Ansprüche 1-3, dadurch gekennzeichnet, daß mehrere elektrisch leitende Schichten entlang der Vorrichtung verteilt sind und unabhängig von getrennten Quellen mit elektrischer Energie versorgt weden.

5. Vorrichtug nach einem der Ansprüche 1-3, dadurch gekennzeichnet, daß mehrere elektrisch leitende Schichten entlang der Vorrichtung verteilt sind, die in Reihe geschaltet sind und von einer gemeinsamen Stromquelle versorgt werden, wobei ein Shunt ($S_2$, $S_3$) veränderbarer Größe zumindest einer der Schichten zugeordnet ist.

6. Vorrichtung nach einem der Ansprüche 1-5, dadurch gekennzeichnet, daß sie innere entfernbare Elemente oder "Patronen" (40, 41, 42) aufweist, die als Träger für die Quelle der zu kristallisierenden Substanz, für das zu entwickelnde Einkristall und für die Substanzmasse dient.

7. Vorrichtung nach Anspruch 6, dadurch gekennzeichnet, daß die Umhüllung quadratischen oder rechteckigen Querschnitt hat und daß das als Träger für das Einkristall dienende Element von mehreren beabstandeten, parallelen Lamellen (44) gebildet wird.

8. Vorrichtung nach Anspruch 6, dadurch gekennzeichnet, daß die Umhüllung kreisförmigen Querschnitt hat und daß das als Trager für das Einkristall dienende Element von konzentrischen Rohren (54) gebildet wird.

**Claims**

1. A transparent heating apparatus having at least two working zones capable of being heated to different temperatures and comprising: an openable transparent chamber, formed from at least two sealably mating, but separable, parts (20, 21), the said chamber being provided with an orifice (22) connectable to a source of vacuum or to means for introducing an atmosphere, characterised in that it includes heating means comprising at least one transparent, resistive, electrically conductive layer (24, 25, 26) applied on the said chamber, and means for applying an electric current to at least two points spaced apart on the said layer, in a manner such as to allow the chamber to be heated by Joule effect, at least one portion of the surface of the chamber being without a resistive, electrically conductive layer, and in that it further includes at least one electrical heating element (60) supplied independently with electrical energy and carried an the said portion of the surface of the chamber not having a resistive, electrically conductive layer, the said element comprising a transparent substrate overlaid on its internal surface with a transparent, resistive, electrically conductive layer, and the said substrate having the form of a plate or a cylindrical section.

2. An apparatus according to Claim 1, characterised in that the resistive, electrically conductive layer is deposited directly on the external surface of the chamber.

3. An apparatus according to Claim 1 or Claim 2, characterised in that the electrically conductive layer is formed of tin oxide and has a thickness of less than two micrometres.

4. An apparatus according to any one of Claims 1 to 3, characterised in that it comprises a plurality of

electrically conductive layers extending longitudinally of the apparatus and supplied independently with electrical energy through separate supplies.

5. An apparatus according to any one of Claims 1 to 3, characterised in that it comprises a plurality of electrically conductive layers extending longitudinally of the apparatus, connected in series and supplied from a single current source, a variable shunt ($S_2$, $S_3$) being associated with at least one of the said layers.

6. An apparatus according to any one of Claims 1 to 5, characterised in that it comprises separable internal elements or "cartridges" (40, 41, 42), for supporting the source of material to be monocrystallised, the monocrystal thereby produced, and the residual material.

7. An apparatus according to Claim 6, characterised in that the chamber is of square or rectangular cross section, and in that the element for supporting the monocrystal comprises a plurality of spaced apart, parallel strips (44).

8. An apparatus according to Claim 6, characterised in that the chamber is of circular cross section, and in that the element for supporting the monocrystal comprises concentric tubes (54).

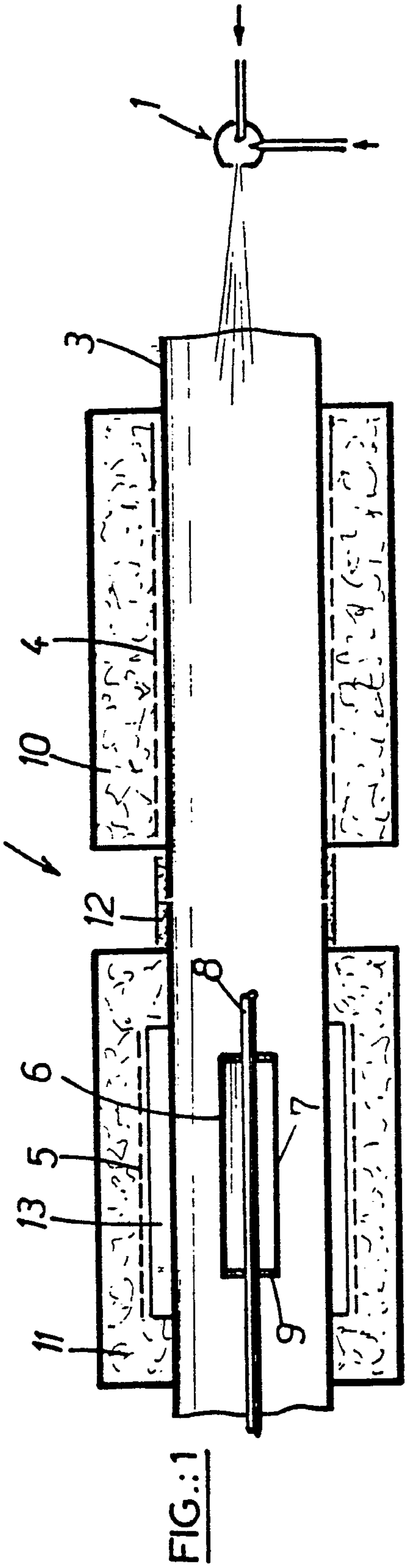


FIG.:1

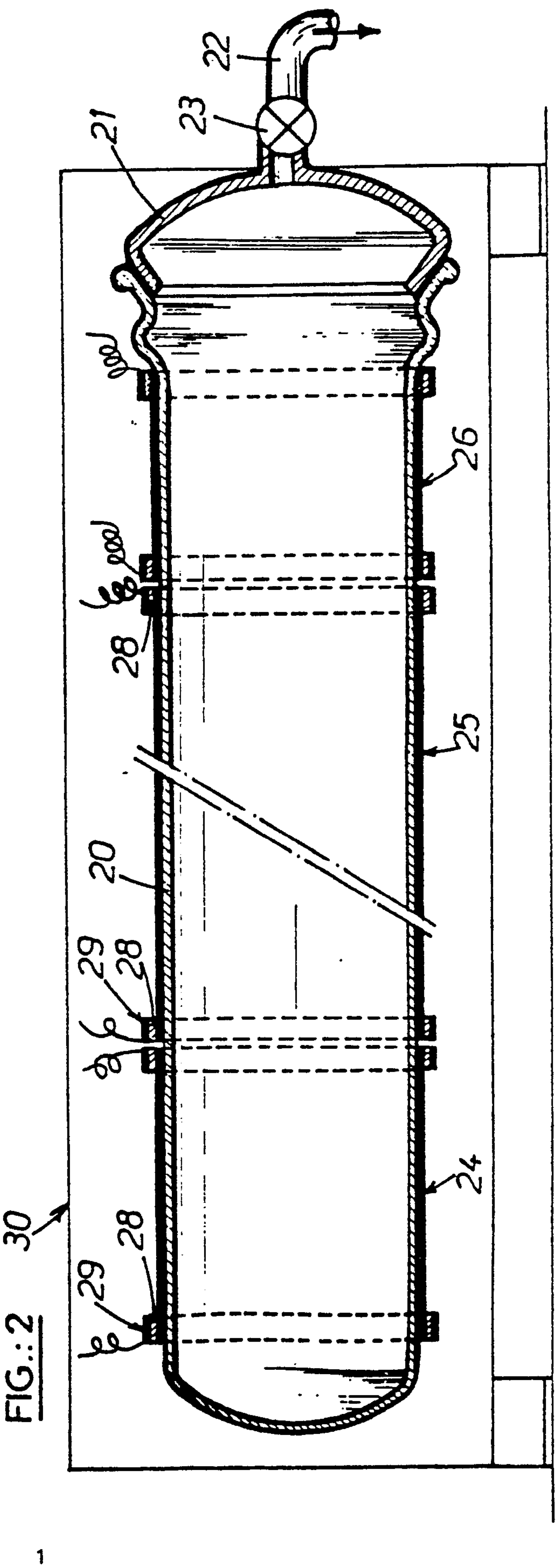


FIG.:2

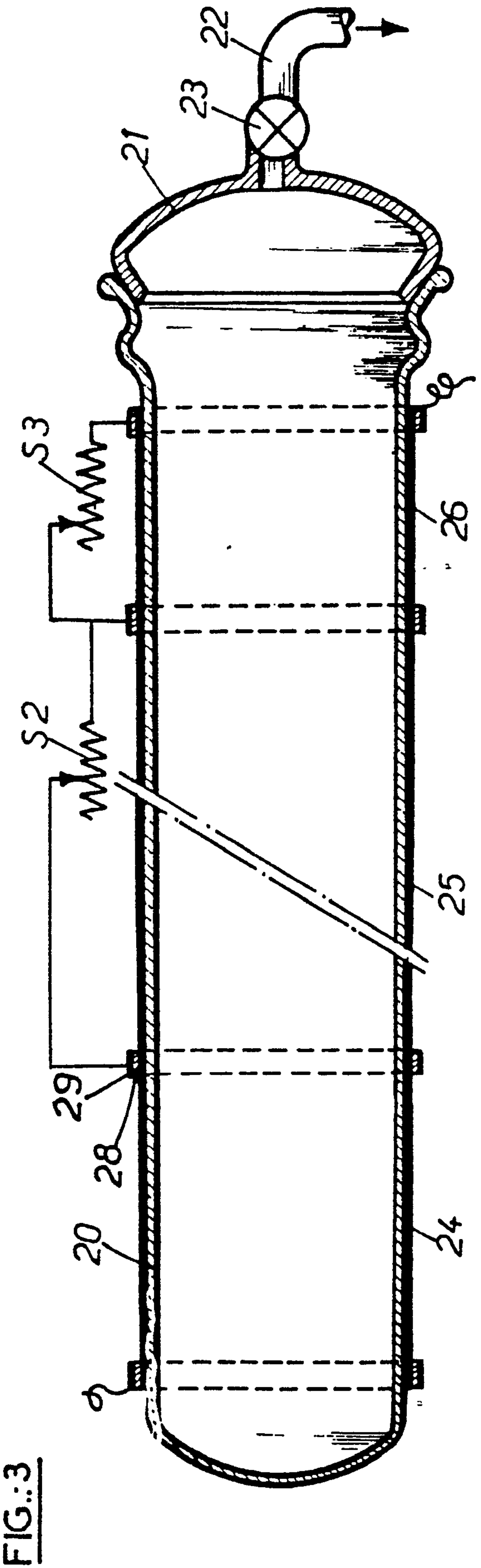
22
23
21
S3
26
S2
25
29
28
20
24

FIG.:3

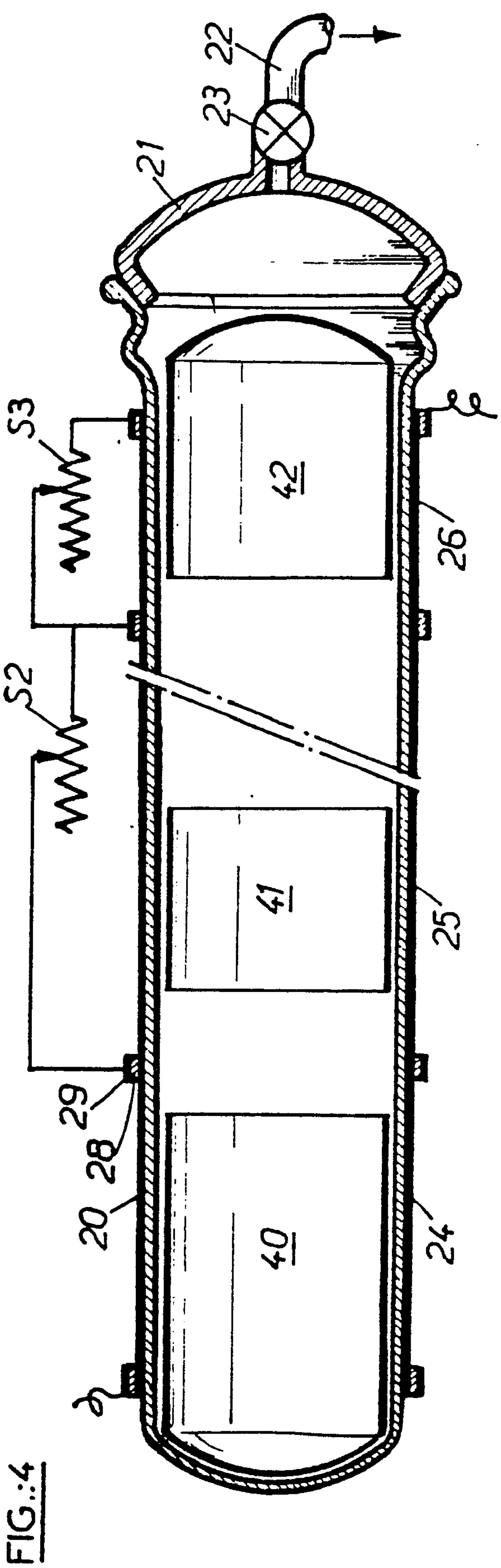
22
23
21
S3
42
26
S2
41
25
29
28
20
40
24

FIG.:4

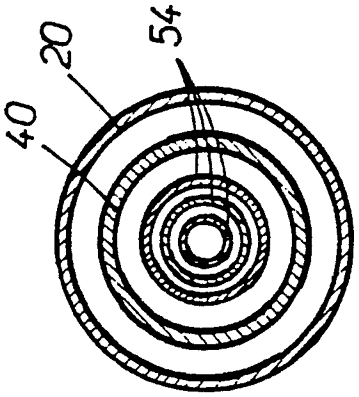


FIG.:6

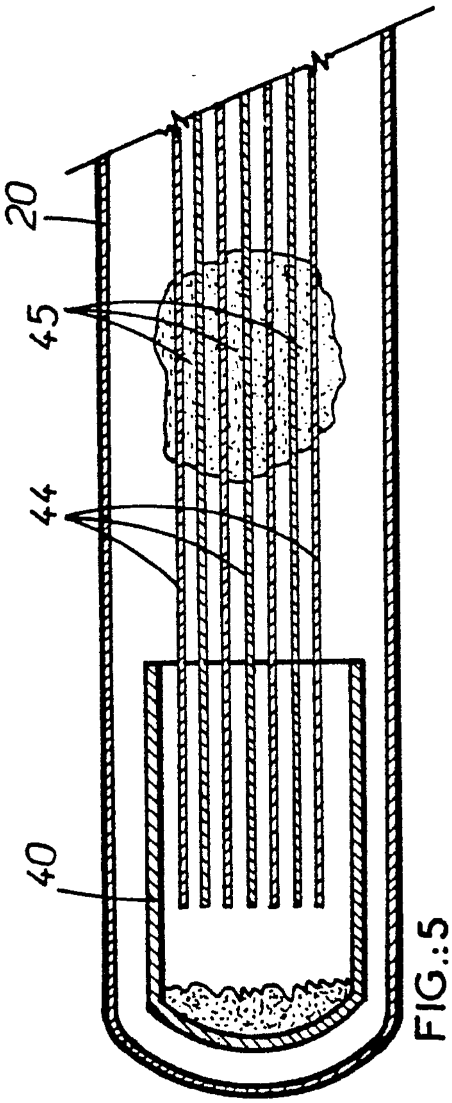


FIG.:5

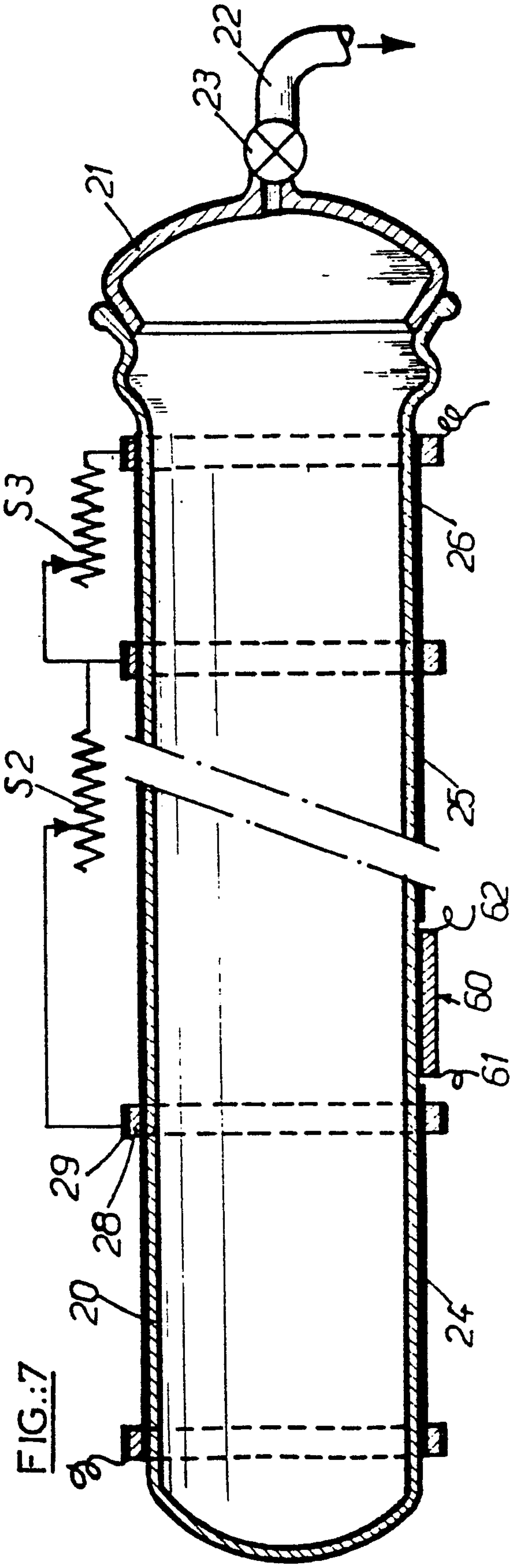


FIG.:7